# EUROPEAN PATENT APPLICATION

(11) **EP 3 745 092 A2**
(43) Date of publication of application: **02.12.2020**
(21) Application number: 20177623.4
(22) Date of filing: 29.05.2020
(51) Int. Cl.: G01D 11/24, G01S 7/481, H03K 17/94, B65G 21/00

(54) **PROXIMITY SENSOR BAR FOR CONVEYOR SYSTEMS**

(30) Priority: 30.05.2019 US 201962854759 P; 31.05.2019 US 201962855608 P; 28.05.2020 US 202016885752
(71) Applicant: Milwaukee Electronics Corporation, Milwaukee, WI 53209 (US)
(72) Inventor: ROCHWERGER, Richard, Hartland, WI 53209 (US); IHNEN, Matthew, Saukville, WI 53080 (US); CASTILLO, Luis, 21430 Tecate Baja California (MX); ALLEN, Michael, Waukesha, WI 53189 (US); MOUA, Vong, Milwaukee, WI 53217 (US)
(74) Representative: Forresters IP LLP

(57) **Abstract**

A proximity sensor bar (12) can be configured to sense or detect the presence or absence of objects on a conveyor system. The proximity bar (12) can implement multiple sensor blocks for such sensing with each sensor block including one or more electronic proximity sensors (52) and with each sensor block being spaced a predetermined distance or interval apart from one another along the bar. The proximity bar (12) comprises a circuit board (30) having a connector to connect to another circuit board and an enclosure (22) to receive the circuit board (30). The proximity bar can be used on conveyor systems, such as roller conveyors in an object movement and distribution environment, with the proximity bar spanning the width of the conveyor. In such systems, the proximity bar could be mounted between adjacent rollers or below such rollers. The proximity bar can also be used on other conveyor systems, such as belted conveyors, by mounting the proximity bar above the conveyor.

## Description

### CROSS-REFERENCE TO RELATED APPLICATION(S)

This application claims priority to U.S. Provisional Patent Application No. 62/855,608, entitled "Proximity Sensor Bar for Conveyor Systems," filed on May 31, 2019, and U.S. Provisional Patent Application No. 62/854,759, entitled "Proximity Sensor Bar for Conveyor Systems," filed on May 30, 2019, which are herein incorporated by reference.

### FIELD OF THE INVENTION

This invention relates generally to detection of objects in conveyor systems. More specifically, the invention relates to a proximity bar that utilizes connectable circuit boards for detection of objects across a conveyor system.

### BACKGROUND

Conveyor systems which move goods or products from one location to another are well known. Typically, one or more controllers are used to control zones of a conveyor system by sensing or detecting the presence of objects and actuating motors to move the objects in response to such detections in a desired manner. However, detectors used in such systems are often cumbersome to install. Moreover, such detectors can be inefficient with regard to the monitoring required in the system. It is therefore desirable to provide an improved system for detection monitoring which overcomes one or more of the foregoing disadvantages.

### SUMMARY OF THE INVENTION

The present invention is directed to a proximity sensor bar ("proximity bar") which can be configured to sense or detect the presence or absence of objects on a conveyor system. The proximity bar can implement multiple sensor blocks for such sensing with each sensor block including one or more electronic proximity sensors and with each sensor block being spaced a predetermined distance or interval apart from one another along the bar. The proximity bar can be used on conveyor systems, such as roller conveyors in an object movement and distribution environment, with the proximity bar spanning the width of the conveyor. In such systems, the proximity bar could be mounted between adjacent rollers or below such rollers. The proximity bar can also be used on other conveyor systems, such as belted conveyors, by mounting the proximity bar above the conveyor. In one aspect, the proximity bar could comprise one or more sensor blocks, such as at least six sensor blocks, spaced a predetermined distance apart from one another along a bar.

The proximity bar can be constructed to accommodate various width conveyors or machines. The proximity bar can comprise one or more printed circuit boards (PCB's) formed as modules which plug into one another in series to thereby form a modular network of a desired length. One module, preferably a first module in the series, can be configured as a master module (or "power supply module" or "control module") with a processor for controlling the proximity bar, a sensor array, and/or a power supply system for receiving external power, conditioning such power and providing the power to subsequent modules, or slave modules (or "sensor modules") having sensor arrays, in the system. The slave modules, which can serve as bar extensions for achieving an overall sensing length across a conveyor system, can efficiently contain only sensor blocks without the overhead of a processor or power supply system. Accordingly, the processor of the master module can control a communication bus and power bus to the slave modules or bar extensions in the proximity bar.

Specifically then, one aspect of the present invention can provide a proximity bar including: a circuit board having a connector for connecting to another circuit board, in which the circuit board includes an electronic sensor for detecting an object; and an enclosure configured to receive the circuit board, the enclosure having a mounting arrangement configured for mounting to a conveyor system.

Another aspect of the invention can provide a proximity bar including: multiple circuit boards connected to one another, each circuit board having a connector configured to connect to another circuit board, in which at least one of the circuit boards has a proximity sensor configured to detect an object; an enclosure configured to receive the circuit boards, and a lens retained by the enclosure, the lens being configured to cover the proximity sensor.

Another aspect of the invention can provide a method for sensing in a conveyor system, including: providing a circuit board having a connector for connecting to another circuit board, in which the circuit board includes an electronic sensor for detecting an object; and providing an enclosure configured to receive the circuit board, the enclosure having a mounting arrangement configured for mounting to a conveyor system.

These and other features and advantages of the invention will become apparent to those skilled in the art from the following detailed description and the accompanying drawings. It should be understood, however, that the detailed description and specific examples, while indicating preferred embodiments of the present invention, are given by way of illustration and not of limitation. Many changes and modifications may be made within the scope of the present invention without departing from the spirit thereof, and the invention includes all such modifications.

According to an aspect of the invention, we provide a proximity bar comprising:
a circuit board having a connector configured to connect to another circuit board, wherein the circuit board includes an electronic sensor configured to detect an object; and
an enclosure configured to receive the circuit board, the enclosure having a mounting arrangement configured for mounting to a conveyor system.

The circuit board may be a first circuit board having a processor, and further comprising a second circuit board having a connector and an electronic sensor, wherein the first and second circuit boards are connected through the connectors, and wherein the processor may be configured to communicate with the electronic sensors of the first and second circuit boards.

The first circuit board may be configured to receive electrical power, condition the electrical power, and provide the conditioned electrical power to the second circuit board through the connectors of the circuit boards for powering the electronic sensor.

The electronic sensor may comprise a non-visible light emitter and receiver.

The mounting arrangement may be configured to allow for mounting to a conveyor system in any one of a plurality of directions.

The enclosure may comprise a channel or groove, and wherein the mounting arrangement is configured to be slidably held in the channel or groove.

The mounting arrangement may comprise a magnet for mounting to the conveyor system.

The proximity bar may further comprise a Light Emitting Diode (LED) indicator configured to flash upon detection of an error or fault condition.

The circuit board may include a non-volatile storage for holding firmware and an interface for re-programming the firmware.

According to a further aspect of the invention, we provide a proximity bar comprising:
a plurality of circuit boards connected to one another, each circuit board having a connector configured to connect to another circuit board, wherein at least one circuit board of the plurality of circuit boards has a proximity sensor configured to detect an object;
an enclosure configured to receive the plurality of circuit boards, and
a lens retained by the enclosure, the lens being configured to cover the proximity sensor.

The lens may be configured at angle with respect to the proximity sensor.

The angle may be at least 10°.

At least one circuit board of the plurality of circuit boards may have a processor, wherein the processor is configured to compare a detection of light through the lens at a first time with a detection of light through the lens at a second time and send an alert if a difference from the comparison is greater than a threshold.

A first circuit board of the plurality of circuit boards may be configured to receive electrical power, condition the electrical power, and provide the conditioned electrical power to a second circuit board of the plurality of circuit boards through the connectors of the circuit boards for powering the proximity sensor.

The proximity sensor may comprise a non-visible light emitter and receiver.

The mounting arrangement may be configured to allow for mounting to a conveyor system in any one of a plurality of directions.

According to a yet further aspect of the invention, we provide a proximity bar comprising:
a circuit board having a processor and a sensor configured to detect an object; and
an enclosure configured to receive the circuit board, the enclosure having a lens and a mounting arrangement configured for mounting to a conveyor system,
wherein the processor is configured to compare a detection of light through the lens at a first time with a detection of light through the lens at a second time and send an alert if a difference from the comparison is greater than a threshold.

The circuit board may be a first circuit board having a processor, and may further comprise providing a second circuit board having a connector and an electronic sensor, wherein the first and second circuit boards may be connected through the connectors, and wherein the processor may be configured to communicate with the electronic sensors of the first and second circuit boards.

The first circuit board may receive electrical power, conditioning the electrical power, and providing the conditioned electrical power to the second circuit board through the connectors of the circuit boards for powering the electronic sensor.

The electronic sensor may comprise a non-visible light emitter and receiver.

### BRIEF DESCRIPTION OF THE DRAWINGS

Preferred exemplary embodiments of the invention are illustrated in the accompanying drawings in which like reference numerals represent like parts throughout, and in which:
FIG. 1 is an isometric view of an exemplary section of a conveyor system including a proximity bar in accordance with an aspect of the invention;
FIG. 2 is an isometric view of a proximity bar in accordance with an aspect of the invention;
FIG. 3 is a cross sectional view of the proximity bar of FIG. 2;
FIG. 4 illustrates an exemplary module contained in a proximity bar in accordance with an aspect of the invention;
FIG. 5 illustrates exemplary modules connected together in a proximity bar in accordance with an aspect of the invention;
FIG. 6 is a detailed view of the exemplary modules of FIG. 5;
FIG. 7 is a detailed view of exemplary alignment and locking fasteners used to align and lock modules in a proximity bar in accordance with an aspect of the invention;
FIGS. 8 and 9 are detailed isometric views of an exemplary section of a conveyor system including a proximity bar in accordance with an aspect of the invention;
FIGS. 10-12 are exemplary isometric views of a proximity bar in accordance with an aspect of the invention;
FIG. 13 is a cross sectional view of the proximity bar in accordance with another aspect of the invention;
FIG. 14 is a cross sectional view of the proximity bar in accordance with another aspect of the invention;
FIGS. 15-17 are cross sectional views of mounting arrangements for a proximity bar in accordance with an aspect of the invention;
FIG. 18 is an isometric view of a proximity bar with a mounting arrangement in accordance with an aspect of the invention;
FIG. 19 is a cross sectional view of a proximity bar in accordance with another aspect of the invention;
FIGS. 20 and 21 illustrate sensor blocks for a proximity bar in accordance with another aspect of the invention;
FIGS. 22 and 23 illustrate mounting arrangements for a proximity bar in accordance with another aspect of the invention;
FIG. 24 is an isometric view of a proximity bar in accordance with another aspect of the invention; and
FIG. 25 is a cross sectional view of the proximity bar of FIG. 24.

### DETAILED DESCRIPTION

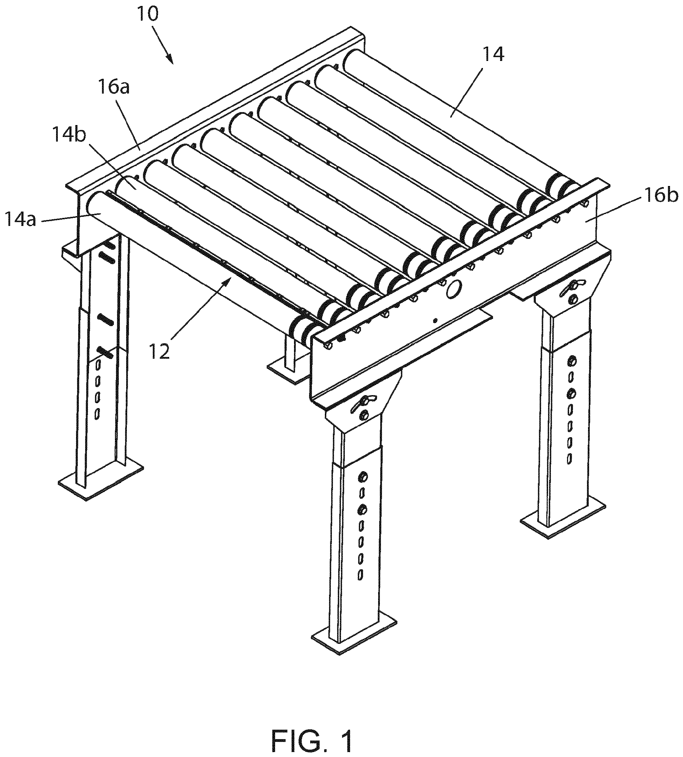

With reference now to the drawings, where like numerals refer to like parts throughout, and specifically with reference to FIG. 1, an exemplary section of a conveyor system 10 including a proximity bar 12 is provided in accordance with an aspect of the invention. The conveyor system 10 could be a roller conveyor comprising multiple rollers 14 for the movement and distribution of objects of various sizes in a commercial or industrial environment. The proximity bar 12 can span the width of the conveyor system 10 by mounting to opposing side rails 16a, 16b of the conveyor through a plurality of orientations as will be described herein. The proximity bar 12 could be mounted between adjacent rollers 14, such as in a gap between first and second rollers 14a and 14b, respectively, or could be mounted below such rollers 14. In an alternative arrangement, which may be particularly suitable for other conveyor systems, such as belted conveyors, the proximity bar 12 could be mounted above the conveyor system 10.

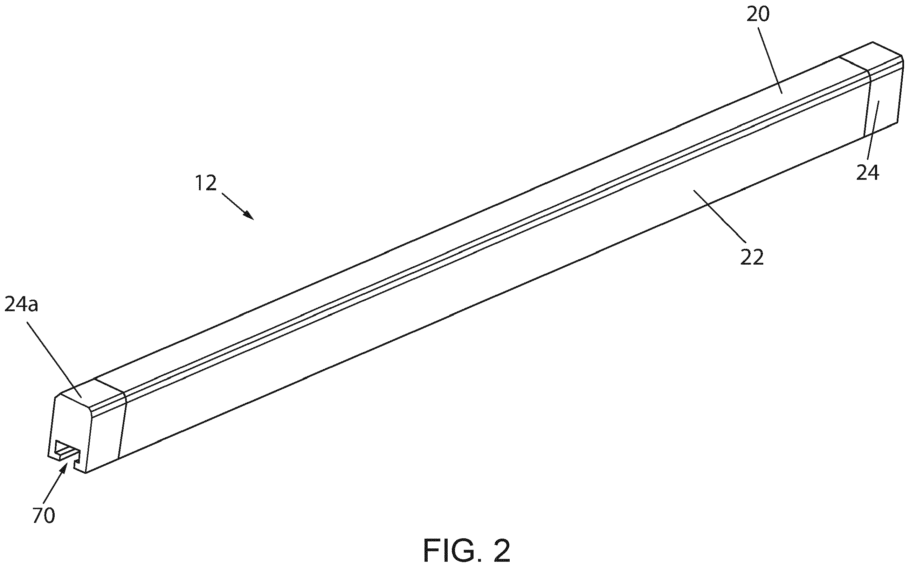

Referring now to FIG. 2, an isometric view of a proximity bar 12 is provided in accordance with an aspect of the invention. The proximity bar 12 could comprise a tube or housing 22 with a single lens or cover 20 arranged along a longitudinal axis of the housing 22, such as on top of the housing 22, with first and second opposing end caps 24a and 24b, respectively, retaining the assembly together. The lens or cover 20 could be configured to slide into position on the housing 22, with ingress protection for the interior of the housing 22, above one or more proximity sensors 52. The housing 22 could be a single structure configured to retain one or more printed circuit boards (PCB's) formed as modules therein. The housing 22 could be an extruded metal, such as aluminum, an alloy or a plastic, any of which being configured with substantial rigidity. In one aspect, the lens or cover 20 could be a layer of plastic or glass configured to protect one or more sensors of the proximity bar 12 from dust, dirt, debris and the like. The lens or cover 20 could be substantially flat. However, in another aspect, the lens or cover 20 could have a curve or shape for optimizing transmission of light with respect to one or more sensors of the proximity bar 12, such as a concave or convex lens. The housing 22 could form a bottom and opposing sides of the proximity bar 12 with the lens or cover 20 being arranged to form a complete top for the proximity bar 12.

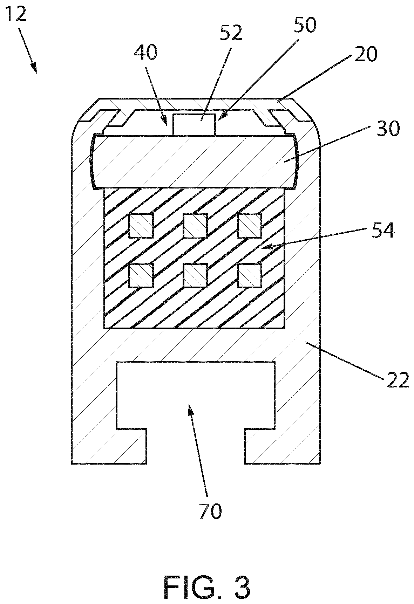

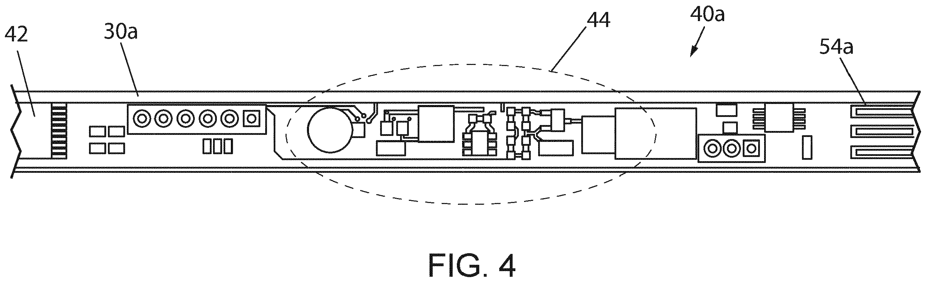

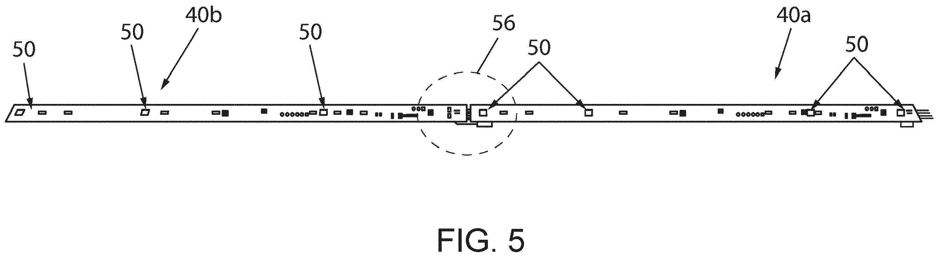

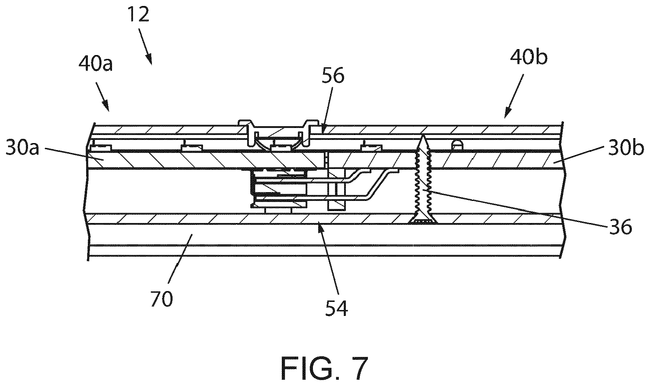

With additional reference to FIGS. 3-9, the proximity bar 12 can be constructed to accommodate various widths of different types of conveyor systems 10. To accommodate such widths, the proximity bar 12 can comprise one or more printed circuit boards (PCB's) 30, each representatively being about 5 to 9.5 inches in length, and each being populated with electrical components to form modules 40, which can plug into one another in series along their lengths to thereby form a modular network of a desired overall length. As may best be seen in FIG. 7, one or more alignment and locking fasteners 36 or screws can be used to properly align and lock each PCB 30, particularly so that each sensor is correctly positioned. Each PCB 30 could be substantially identical in size, shape, dimension and layout, and particularly having identical length in a longitudinal direction of the bar. However, one PCB 30a, preferably a first PCB 30 in the series, can be populated with a first set of electrical components to form a master module 40a of the proximity bar 12, while one or more additional PCB's 30b, preferably subsequent PCB's 30 in the series, can be populated with a second set of electrical components to form slave modules 40b of the proximity bar 12 to achieve the desired length.

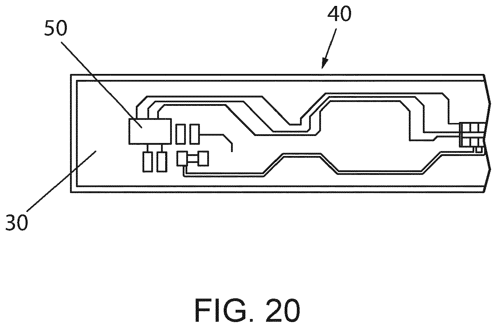

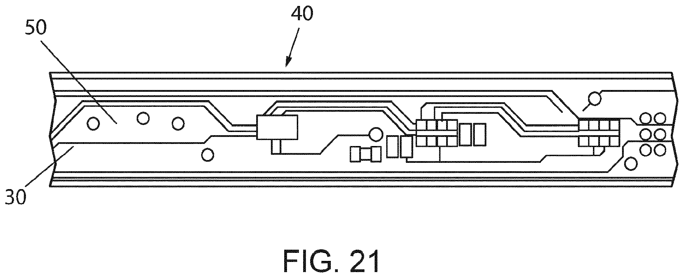

The first set of electrical components of the master module 40a could comprise, among other things: a processor 42, implemented by a microcontroller, for controlling the proximity bar 12, including the slave modules 40b; a power supply system 44 for receiving external power, conditioning such power and providing the power to subsequent slave modules 40b for powering such modules in the system; firmware, providing configuration data for the module in a non-volatile storage; and/or one or more sensor blocks 50 (see FIGS. 3, 5, 20 and 21, for example), each comprising one or more proximity sensors 52, which sensors could be arranged in one or more locations in the sensor block. The power supply system could comprise, for example, a DC-to-DC converter to allow operation at a standard industrial voltage of 24 VDC. In one aspect, the one or more sensor blocks 50 could be arranged on a bottom of the PCB 30a while the processor 42 and/or power supply system 44 are arranged on a top of the PCB 30a.

The second set of electrical components of the slave modules 40b could comprise, among other things: one or more sensor blocks 50, each comprising one or more sensors; communications circuitry for communicating with the master module 40a, through one or more adjacent modules 40; firmware, providing configuration data for the module in a non-volatile storage; and/or power circuitry for receiving power from the master module 40a, through one or more adjacent modules 40, and distributing such electrical power to the one or more sensor blocks 50 and/or the communications circuitry. The communications circuitry can be operable to implement an I²C (Inter-Integrated Circuit) bus for communication among each of the modules 40, including communication with the processor 42 of the master module 40a. In one aspect, the one or more sensor blocks 50 could be arranged on a bottom of a PCB 30b while the communications circuitry and/or power circuitry are arranged on a top of the PCB 30b. The slave modules 40b, which can serve as bar extensions for achieving a desired overall sensing length across the conveyor system 10, can efficiently contain only sensor blocks without the overhead of a processor or power supply system. Accordingly, the processor 42 of the master module 40a can control a communication bus and a power bus to the slave modules 40b or bar extensions in the proximity bar 12.

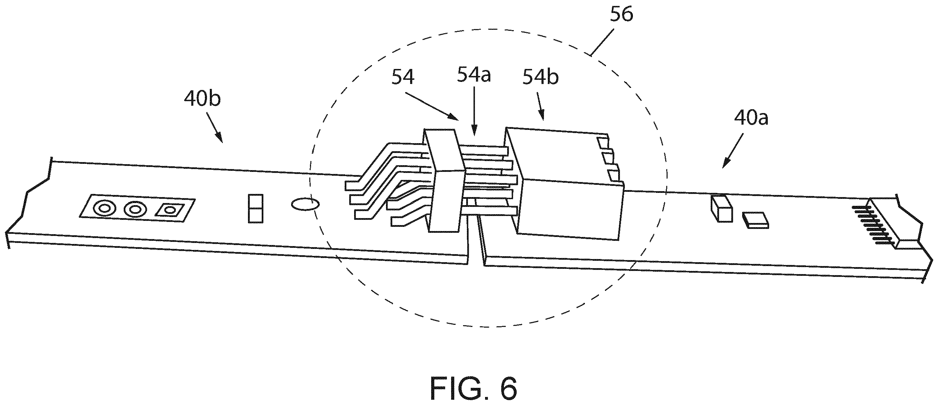

Each of the modules 40 can include a connector arrangement 54 for connecting to other modules 40 in series at module intersections 56 on opposing sides of the module. The connector arrangement 54 can include a first connector portion 54a, such as a male connector with leading pins, at an end of the module, and a second connector portion 54b, such as a female connector with sockets for receiving the leading pins, at the other end of the module. Alternatively, flexible conductors of any length, such as a ribbon cable, could be used to connect the first and second connector portions 54a and 54b, respectively. As shown particularly in FIGS. 6 and 7 by way of example, a first connector portion 54b of the master module 40a is connected to a second connector portion 54a of the slave module 40b in series at a module intersection 56. The slave module 40b can further include a first connector portion 54b of its own at an opposing end for connecting to a second connector portion 54a of another slave module 40b at another module intersection 56 on the opposing end. Accordingly, multiple modules 40 can be connected together in series, being connectable in this way to achieve the desired length. In one aspect, the proximity bar 12 could include two separate modules 40, connected to one another. Achieving a greater length can be accomplished by adding more modules 40. The first module 40 in the series, which may typically be a master module 40a, need not include a connector portion 54 at opposing ends, but rather could include a connector portion 54 at one end (for connecting to another module 40) and an output for connecting to a central network at the other end.

The connector arrangement 54 can connect multiple signals from the leading pins of one module 40 to the socket of another module 40. Such signals could include, for example: one or more communications signals, such as for communicating updates from the master module 40a to the slave modules 40b; one or more power and/or ground signals for transferring power and/or ground from the master module 40a to the slave modules 40b; and one or more interrupt signals, such as for allowing a slave module 40b to communicate detection of an object to the master module 40a. In one example, the communications signals may comprise an PC bus. A module 40 could be configured to assert an interrupt signal high, such as to 24V DC, upon a sensor 52 of the module 40 detecting an object. Alternatively, a module 40 could be configured to assert an interrupt signal low, such as to GND, upon a sensor 52 of the module 40 detecting an object. Then, the processor 42, in turn, can assert an output signal to a central network (not shown) to indicate such detection of the object.

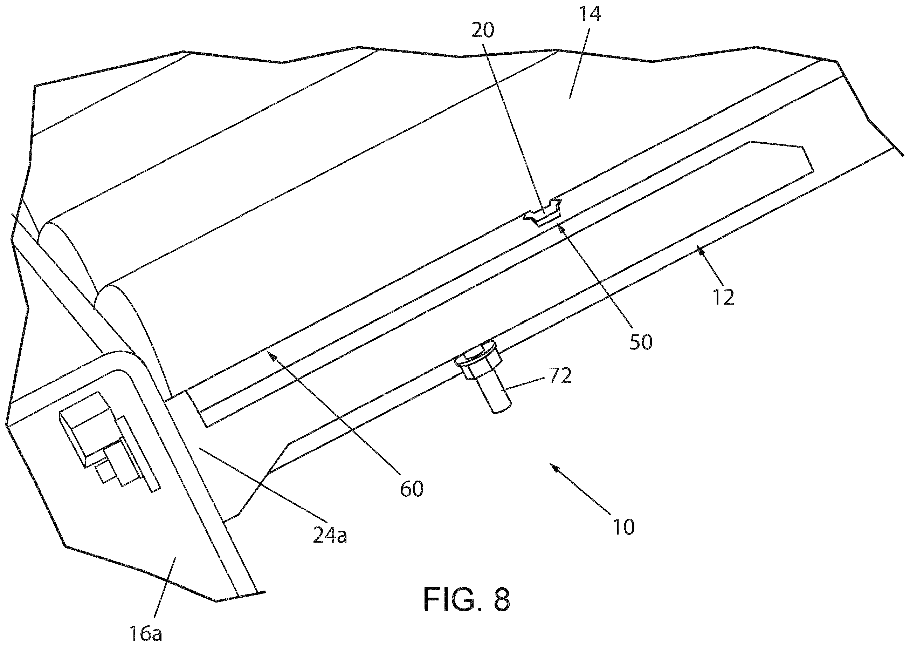

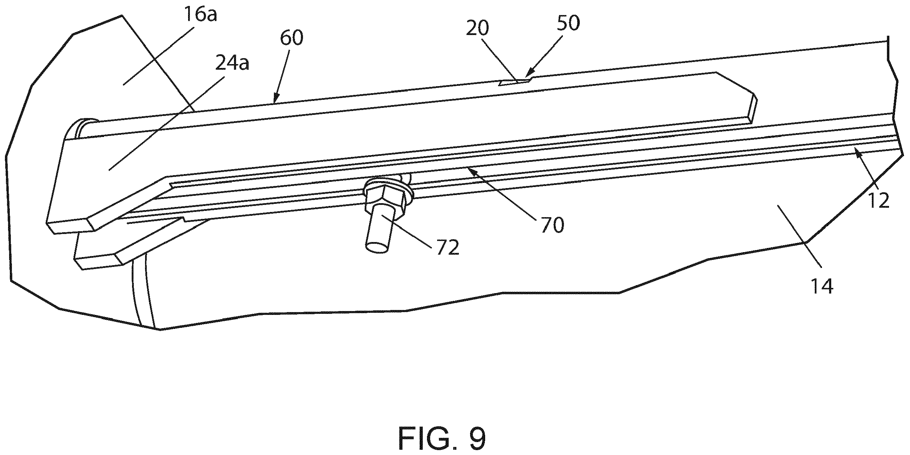

With additional reference to FIGS. 8 and 9, the proximity bar 12 operates by continuously monitoring the multiple sensor blocks 50 for objects moving along the conveyor system 10. In one aspect, the proximity bar 12 could comprise, for example, at least six sensor blocks 50 spaced a predetermined distance apart from one another along a bar with two modules 40, including a master module 40a and a slave module 40b. Each sensor block 50 can comprise one or more sensors 52 formed by integrated circuits, with each sensor 52 comprising an emitter and a receiver. The sensor 52 could be an optical sensor configured for continuously emitting (or transmitting) a focused, predetermined wavelength of light from the emitter, such as an Infrared laser, while simultaneously detecting a reflection of such light by the receiver. The receiver detecting a reflection of the light above a predetermined threshold can indicate presence of an object on the conveyor system due to reflection of the light by the object. Conversely, the receiver failing to detect a reflection of the light above the threshold can indicate absence of an object on the conveyor system due to an absence of reflection of the light by an object. The sensor 52 could comprise any non-visible light emitter and receiver. In one aspect, the sensor 52 could comprise a vertical-cavity surface-emitting laser (VCSEL), infrared or near-infrared. The sensor 52 could also comprise discrete elements, such as a Light Emitting Diode (LED) emitter and receiver provided in separate component packages. The emitter and receiver components could be mounted, for example, in separate cavities on the circuit board, which cavities may be separated by a barrier configured to provide optical isolation.

In one aspect, the one or more sensors 52 of each sensor block 50 could be configured for detection at a given threshold for the sensor 52, which thresholds could be calibrated for the environment, and which thresholds could be different from one sensor 52 to another. If any sensor of a sensor block 50 exceeds its respective threshold, a signal can be generated by the sensor 52 and sent to a processor to thereby indicate presence or detection of an object. The sensor blocks 50 can detect presence of an object from a variety of distances which may depend on the technology used, lens and/or cover implementations, and/or programmability of the sensor block 50. In one aspect, a sensor of the sensor block 50 can detect an object that is at least 0.5 inches away.

The proximity bar 12 can be configured to help a user in preventative maintenance for dust management. For many applications, and particularly for conveyor applications, dust or dirt can accumulate on the lens or cover 20 of sensor blocks 50, thereby impeding light output and/or reception of reflected signal. If the lens or cover 20 becomes significantly blocked, reliability of such sensor blocks 50 to detect presence of objects may be reduced. Accordingly, the present invention also provides a method in which a user can be alerted to dust or dirt accumulation on lenses or covers 20 which exceed a threshold. For example, the processor 42 can be configured to compare a detection of light, at a sensor 52 of a given sensor block 50, through a lens or cover 20, at a first time, with a detection of light through the same lens or cover 20 at a second time. If a difference from the comparison is greater than a threshold, thereby indicating an excessive accumulation of dust or dirt on the lens or cover 20 limiting the transmission of light, the processor 42 can send an alert to a central network and/or illuminate flash codes at an indicator 60 comprising one or more Light Emitting Diodes (LED's) to suggest a maintenance action. In one aspect, for comparing the detection of light at different times, the processor can determine a given number of counts from an amount of light detected at the sensor at each time. The processor can then compare the counts at the different times. Typically, the number of counts that the sensor may output will vary from a predetermined threshold after a period of time. This variation is known as "drift," which may be caused by dust accumulation on the lens or cover 20. The processor can further execute to apply an average and/or filter of data collected from the sensor, determining the counts, for tracking such drift. Accordingly, a correct threshold window can be maintained for proper operation of sensors providing detection through the lens or cover 20, typically for determining the presence of an object on a conveyor.

For detection of objects, sensors of each sensor block 50 can convert a reflective, measured light signal into a corresponding number of "counts" indicating a relative strength or sum of such reflective light. Due to variations in each integrated circuit of each sensor 52, an "offset" value can be configured for each sensor block 50. Such offset value could be stored in the proximity bar 12 for each sensor 52 at the time of manufacturing, such as in non-volatile storage of each module 40. At various intervals, the proximity bar 12 could measure the offset and compare such measurement to the stored value to determine if the value has changed. Such an offset change could indicate that the lens or cover 20 is being blocked, thereby causing the sensor 52 to lose its ability to measure effectively. When a large enough change in the offset is determined, the proximity bar 12 could trigger an alert to the user, such as by flashing the indicator 60, sounding an audible alarm, communicating a message indicating the offset change over a central network, and/or the like.

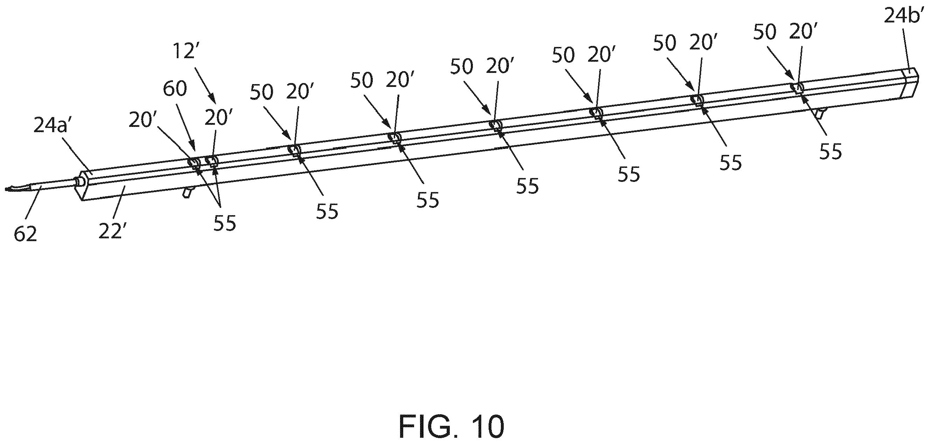

Referring now to FIG. 10, in another aspect of the invention, a proximity bar 12' could comprise a circumferentially formed tube or housing 22' having a top, a bottom and opposing sides, flanked by first and second opposing end caps 24a' and 24b', respectively, for completely enclosing the modules 40. The housing 22' could include multiple openings or apertures 55, arranged along a longitudinal axis of the bar, such as on the top, which are positioned over sensor blocks 50 of modules 40 arranged inside the proximity bar 12'. Multiple lenses or covers 20', in turn, can be retained by the housing 22'at each aperture 55, over the sensor blocks 50, for maximizing sensing efficiency.

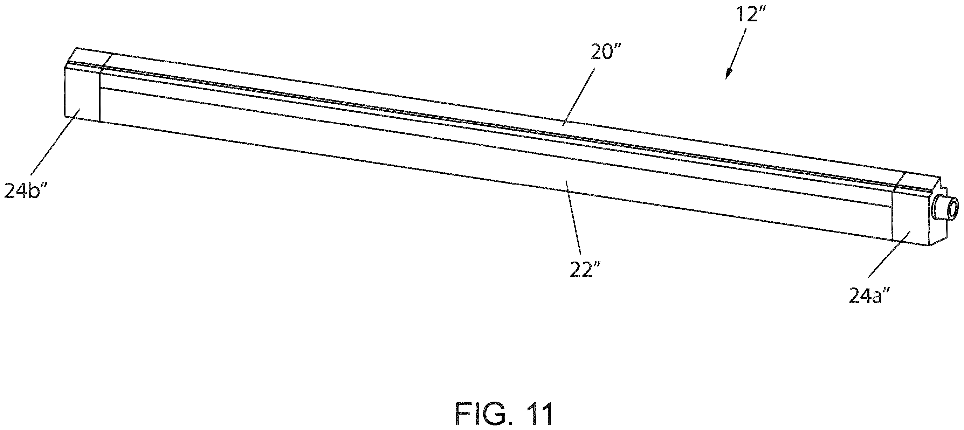

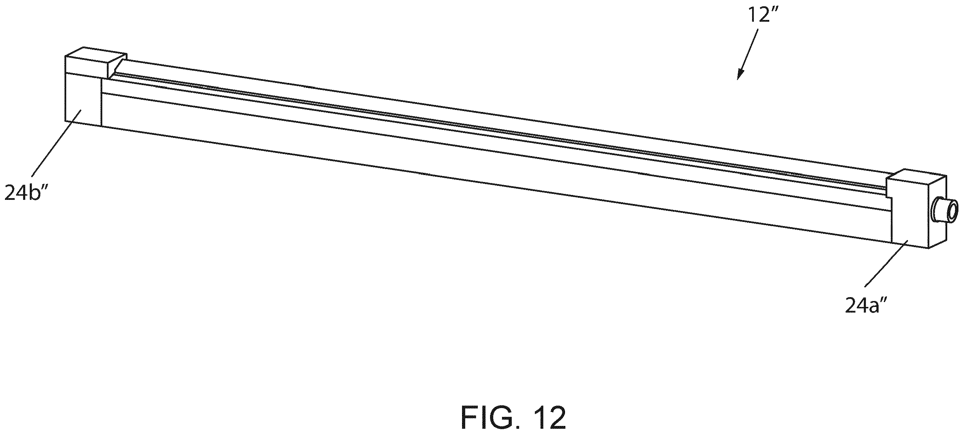

Referring now to FIGS. 11-14, in another aspect of the invention, a proximity bar 12" could comprise one or more lenses or covers 20" configured at an angle θ with respect to the sensor block 50. In one aspect, the proximity bar 12" could comprise a tube or housing with a single lens or cover 20" arranged along a longitudinal axis of the housing, such as on top of the housing, with opposing end caps retaining the assembly together, similar to the embodiment of FIG. 2. In another aspect, the proximity bar 12" could comprise a circumferentially formed tube or housing having a top, a bottom and opposing sides, flanked by opposing end caps, for completely enclosing the modules 40, with multiple openings or apertures 55 arranged along a longitudinal axis of the housing over sensor blocks 50, and with lenses or covers 20" retained by the housing at the apertures, similar to the embodiment of FIG. 10. Also, in one aspect, as shown in FIG. 11, the proximity bar 12" could include first and second opposing end caps 24a" and 24b", respectively, for retaining the assembly together and/or completely enclosing the modules 40, which are also configured at the angle θ in a form fit manner with the lens or cover 20" for a positive fit. In another aspect, as shown in FIG. 12, the proximity bar 12'" could include first and second opposing end caps 24a'" and 24b'", respectively, for retaining the assembly together and/or completely enclosing the modules 40, which are not configured at the angle θ, but rather at substantially right angles.

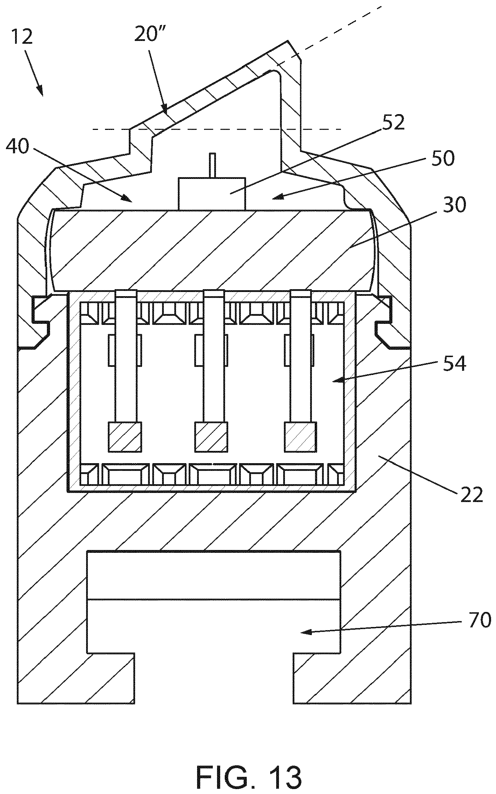

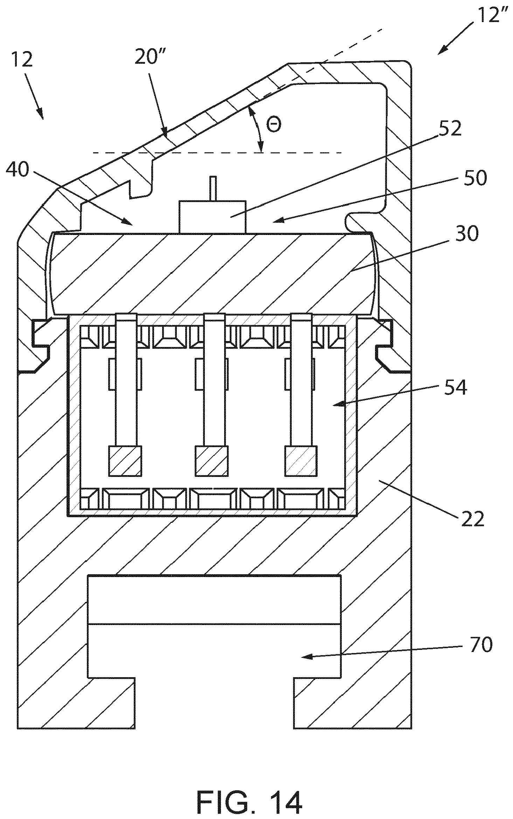

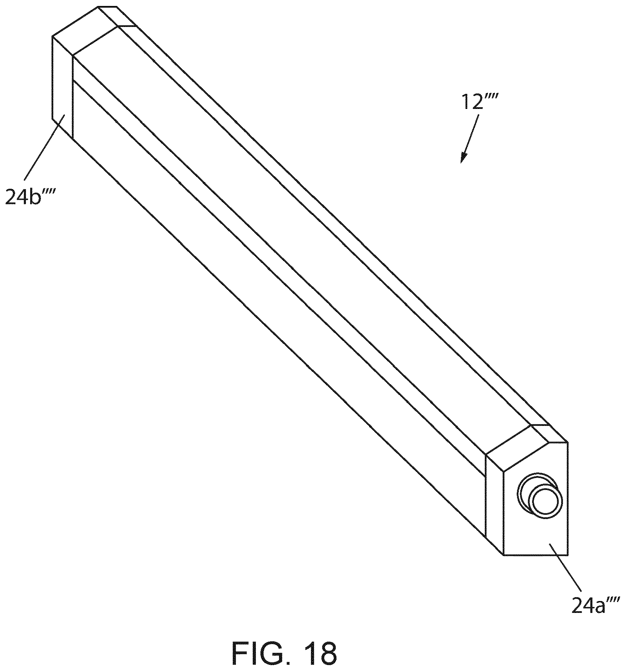

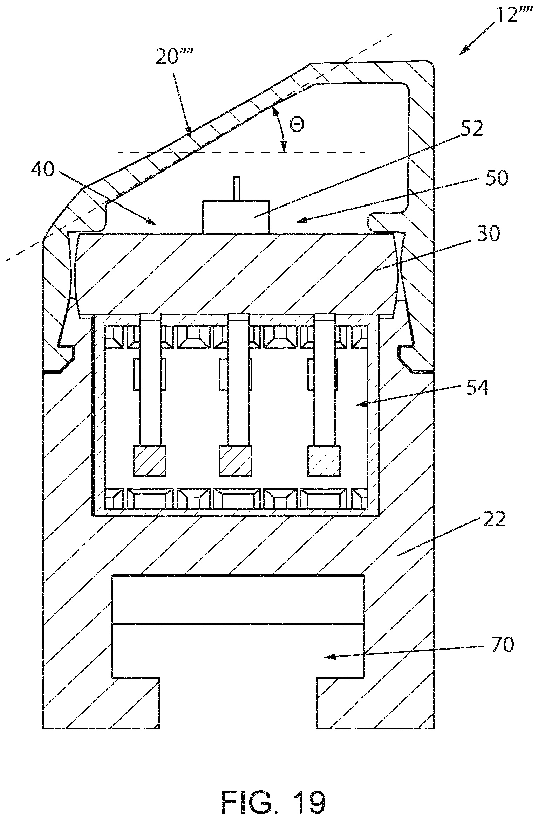

Providing the lens or cover 20 at the angle θ can allow light transmitted by the sensor 52 to be better dispersed external to the proximity bar 12. This, in turn, can substantially reduce undesirable over saturation of light as reflected by an object onto the receiver of the sensor 52 (which over saturation could prevent reliable detection). In one aspect, the angle θ can be at least 10°, and preferably about 30°. In one aspect, as shown in FIG. 13, the lenses or covers 20" can be configured at the angle θ strictly in areas above the sensor blocks 50. This might be used, for example, in embodiments having multiple apertures and multiple lenses or covers over the apertures. In another aspect, as shown in FIG. 14, the lenses or covers 20" can be configured at the angle θ more broadly over the module 40. This might be used, for example, in embodiments having a single lens or cover over the bar. See also additional aspects as shown in FIGS. 18 and 19.

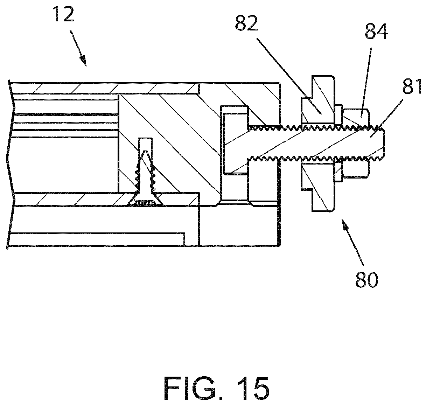

Referring now to FIGS. 15-17, a proximity bar 12 can include various connectivity and mounting arrangements in accordance with aspects of the invention. For connectivity, an electrical cable 62 can provide power and/or communications to the proximity bar 12. The electrical cable 62 can be received by a connector of the master module 40a in the proximity bar 12 for distributing power to the power supply system 44 and/or enabling communications between the processor 42 and a central network (not shown). Power to the proximity bar 12 could comprise, for example, 24V DC and/or GND signals derived from an external power source, such as an electrical grid or power generator (not shown).

For mounting the proximity bar 12, as may best be seen in FIG. 3 for example, in one aspect, a groove or channel 70 can be formed along a longitudinal axis of the bar, such as on the bottom of the bar. The channel 70 can be substantially "T-shaped" with interior edges for providing retention. As may best be seen in FIGS. 8 and 9 for example, the channel 70 being shaped in this way can allow retention of multiple fasteners 72 by the interior edges. The fasteners 72, in turn, can provide retention to the conveyor system, e.g. using brackets secured to the frame of the conveyor system.

As may best be seen in FIG. 15 for example, in another aspect, a mounting arrangement 80 can be configured on either side of the proximity bar 12 for engaging the opposing side rails 16a, 16b of the conveyor system 10. The mounting arrangement 80 could comprise a side mount fastener 81 securing the proximity bar 12 to a side rail 16, with the side mount fastener 81 securely attaching to an interior retention piece 82, arranged interior to the side rail 16, and an exterior retention piece 84, arranged exterior to the side rail 16. This configuration advantageously allows the proximity bar 12 to be oriented in any one of an infinite number of directions (a plurality of continuous directions) as desired by the user, which may be outward radial directions through 360 degrees of a circle.

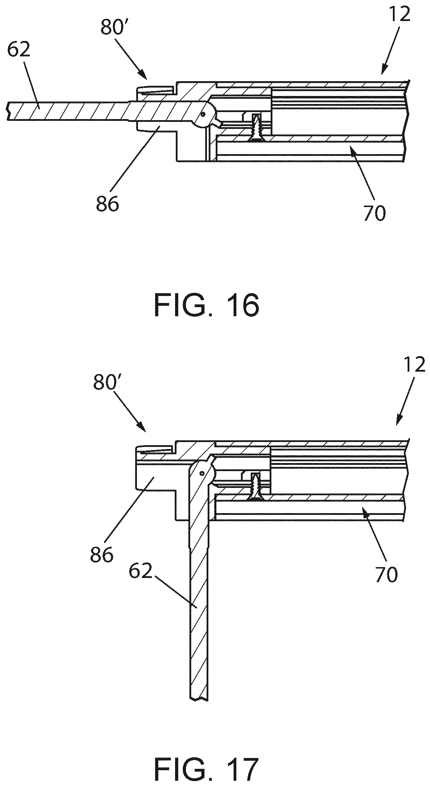

As may best be seen in FIGS. 16 and 17 for example, in another aspect, a mounting arrangement 80' can be configured on either side of the proximity bar 12 for engaging the opposing side rails 16a, 16b of the conveyor system 10. The mounting arrangement 80' could comprise a form fit connection piece 86 which could be secured to a corresponding opening or aperture in either side rail 16. The form fit connection piece 86 can advantageously allow passage of the electrical cable 62 therethrough, either in a direction following a longitudinal axis of the bar, as shown in FIG. 16, or in a direction normal to the longitudinal axis of the bar, as shown in FIG. 17.

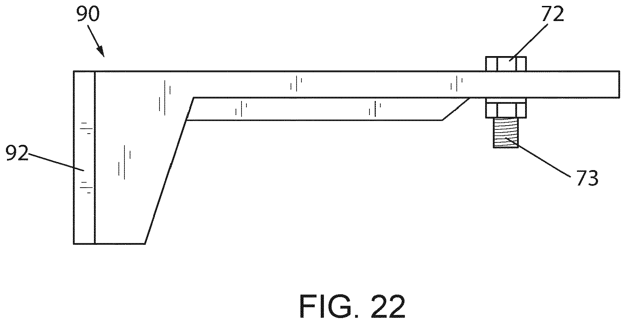

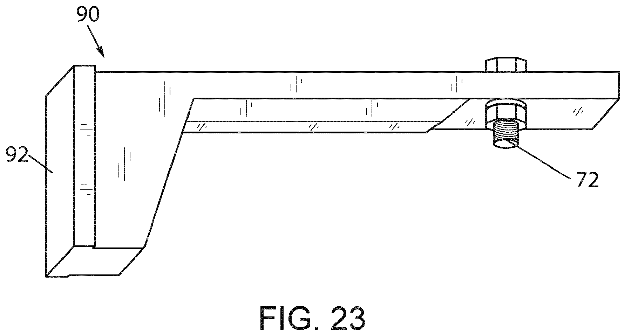

Referring now to FIGS. 22 and 23, in another aspect, a mounting arrangement 90 comprising a support mechanism or bracket can be connected or arranged in the groove or channel 70 of the proximity bar 12 (see also FIG. 3) for securing the proximity bar 12 to the conveyor system 10. The proximity bar 12 can slidably receive the mounting arrangement 90 at each end in the channel 70, in the substantially "T-shaped" track, along the longitudinal axis of the bar. The fastener 72 can provide added retention of the mounting arrangement 90 to the proximity bar 12, preventing any slidable movement when tightened, such as by an opposing nut 73. In addition, the mounting arrangement 90 can include a magnetic end piece 92 for magnetically engaging an opposing magnetic pole configured with respect to a side rail 16 of the conveyor system 10. Accordingly, with a mounting arrangement 90 configured at each end of the proximity bar 12, the proximity bar 12 can be magnetically mounted and secured to the conveyor system 10, oriented in any one of an infinite number of directions as desired by the user.

As discussed above, the modules 40 can each include, among other things, firmware providing configuration data for the modules in a non-volatile storage. Such firmware can be initially programmed when the proximity bar 12 is manufactured and re-programmed, as desired, after the proximity bar 12 is installed in the conveyor system 10. Re-programmability can be accomplished by a central network (not shown) communicating a firmware update to the processor 22 through a "smart" interface, via a wired or wireless connection, for updating the firmware. The wired connection could be established, for example, through the electrical cable 62. The wireless connection could be established, for example, through a Bluetooth, Infrared Data Association (IrDA) or Wi-Fi connection, implemented on the module 40.

In addition, in one aspect, an LED of the indicator 60 could be used for conducting diagnostics or tests with respect to the proximity bar 12. If an error or fault condition is detected, an alert can be sent to the user via the indicator 60. Such alerts could include, for example: an error detected with respect to the non-volatile storage of a module 40; failing to detect a module 40 that is expected to be present, failing to detect a sensor block 50 that is expected to be present; an excessive accumulation of dust, dirt or debris on the lens or cover 20, as discussed above; and the like. Also, the indicator 60 could flash or blink in a sequence to indicate a code for correspondingly informing the user as to precisely which error or fault condition has occurred. Moreover, the code, and/or additional report data, such as addresses, timestamps, and the like, could be communicated by the proximity bar 12 to the central network through the aforementioned smart interface, via the wired or wireless connection.

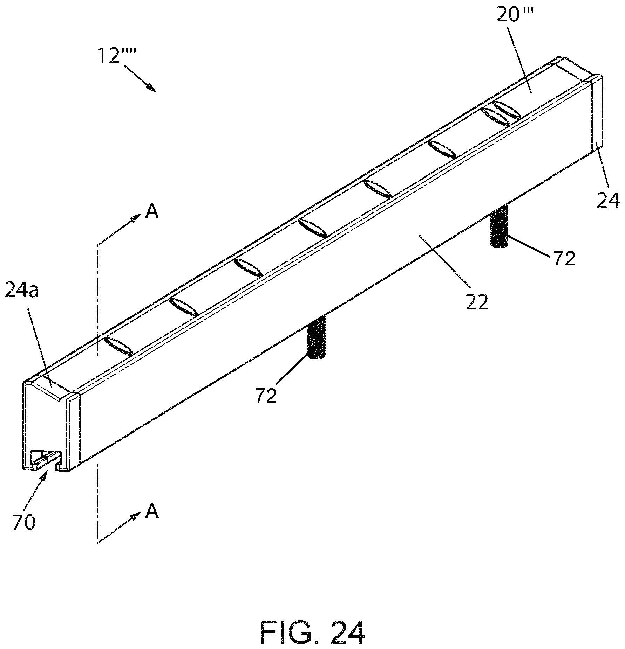

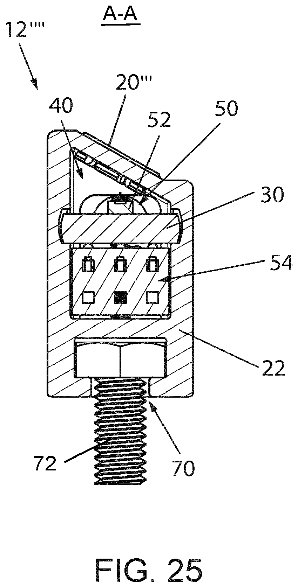

Finally, with additional reference to FIG. 24, an isometric view of a proximity bar 12"", with fasteners 72 in the channel 70, is provided in accordance with another aspect of the invention. In addition, with reference to FIG. 25, a cross sectional view of the proximity bar 12"", and fastener 72, taken along A-A, is provided. The proximity bar 12"" could include a lens or cover 20'" arranged at an angle, like the lens or cover 20" of FIG. 12, but with less surface area on the top of the housing.

It should be understood that the invention is not limited in its application to the details of construction and arrangements of the components set forth herein. The invention is capable of other embodiments and of being practiced or carried out in various ways. Variations and modifications of the foregoing are within the scope of the present invention. It also being understood that the invention disclosed and defined herein extends to all alternative combinations of two or more of the individual features mentioned or evident from the text and/or drawings. All of these different combinations constitute various alternative aspects of the present invention. The embodiments described herein explain the best modes known for practicing the invention and will enable others skilled in the art to utilize the invention.

When used in this specification and claims, the terms "comprises" and "comprising" and variations thereof mean that the specified features, steps or integers are included. The terms are not to be interpreted to exclude the presence of other features, steps or components.

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

Although certain example embodiments of the invention have been described, the scope of the appended claims is not intended to be limited solely to these embodiments. The claims are to be construed literally, purposively, and/or to encompass equivalents.

## Claims

1. A proximity bar comprising:
a circuit board having a connector configured to connect to another circuit board, wherein the circuit board includes an electronic sensor configured to detect an object; and
an enclosure configured to receive the circuit board, the enclosure having a mounting arrangement configured for mounting to a conveyor system.

2. The proximity bar of claim 1, wherein the circuit board is a first circuit board having a processor, and further comprising a second circuit board having a connector and an electronic sensor, wherein the first and second circuit boards are connected through the connectors, and wherein the processor is configured to communicate with the electronic sensors of the first and second circuit boards.

3. The proximity bar of claim 2, wherein the first circuit board is configured to receive electrical power, condition the electrical power, and provide the conditioned electrical power to the second circuit board through the connectors of the circuit boards for powering the electronic sensor.

4. The proximity bar of any preceding claim, wherein the electronic sensor comprises a non-visible light emitter and receiver.

5. The proximity bar of any preceding claim, wherein the mounting arrangement is configured to allow for mounting to a conveyor system in any one of a plurality of directions.

6. The proximity bar of claim 5, wherein the enclosure comprises a channel or groove, and wherein the mounting arrangement is configured to be slidably held in the channel or groove.

7. The proximity bar of claim 5 or claim 6, wherein the mounting arrangement comprises a magnet for mounting to the conveyor system.

8. The proximity bar of any preceding claim, further comprising a Light Emitting Diode (LED) indicator configured to flash upon detection of an error or fault condition.

9. The proximity bar of any preceding claim, wherein the circuit board includes a non-volatile storage for holding firmware and an interface for re-programming the firmware.

10. A proximity bar comprising:
a plurality of circuit boards connected to one another, each circuit board having a connector configured to connect to another circuit board, wherein at least one circuit board of the plurality of circuit boards has a proximity sensor configured to detect an object;
an enclosure configured to receive the plurality of circuit boards, and
a lens retained by the enclosure, the lens being configured to cover the proximity sensor.

11. The proximity bar of claim 10, wherein the lens is configured at angle with respect to the proximity sensor.

12. The proximity bar of claim 11, wherein the angle is at least 10°.

13. The proximity bar of any one of claims 10 to 12, wherein at least one circuit board of the plurality of circuit boards has a processor, wherein the processor is configured to compare a detection of light through the lens at a first time with a detection of light through the lens at a second time and send an alert if a difference from the comparison is greater than a threshold.

14. The proximity bar of any one of claims 10 to 13, wherein a first circuit board of the plurality of circuit boards is configured to receive electrical power, condition the electrical power, and provide the conditioned electrical power to a second circuit board of the plurality of circuit boards through the connectors of the circuit boards for powering the proximity sensor.

15. The proximity bar of any one of claims 10 to 14, wherein the proximity sensor comprises a non-visible light emitter and receiver.

16. The proximity bar of any one of claims 10 to 15, wherein the mounting arrangement is configured to allow for mounting to a conveyor system in any one of a plurality of directions.

17. A proximity bar comprising:
a circuit board having a processor and a sensor configured to detect an object; and
an enclosure configured to receive the circuit board, the enclosure having a lens and a mounting arrangement configured for mounting to a conveyor system,
wherein the processor is configured to compare a detection of light through the lens at a first time with a detection of light through the lens at a second time and send an alert if a difference from the comparison is greater than a threshold.

18. The proximity bar of claim 17, wherein the circuit board is a first circuit board having a processor, and further comprising providing a second circuit board having a connector and an electronic sensor, wherein the first and second circuit boards are connected through the connectors, and wherein the processor is configured to communicate with the electronic sensors of the first and second circuit boards.

19. The proximity bar of claim 17 or claim 18, further comprising the first circuit board receiving electrical power, conditioning the electrical power, and providing the conditioned electrical power to the second circuit board through the connectors of the circuit boards for powering the electronic sensor.

20. The proximity bar of claim 17, 18 or 19, wherein the electronic sensor comprises a non-visible light emitter and receiver.
